(19) Europäisches Patentamt
European Patent Office
Office européen des brevets

(11) **EP 4 637 038 A1**

(12) **EUROPEAN PATENT APPLICATION**

(43) Date of publication:
**22.10.2025 Bulletin 2025/43**

(21) Application number: **25170660.2**

(22) Date of filing: **15.04.2025**

(51) International Patent Classification (IPC):
*H03M 13/29* (2006.01)   *H03M 13/37* (2006.01)
*H03M 13/00* (2006.01)   *H04L 1/00* (2006.01)
*G06N 3/0455* (2023.01)   *H03M 13/13* (2006.01)
*H03M 13/21* (2006.01)   *H03M 13/09* (2006.01)
*H03M 13/45* (2006.01)

(52) Cooperative Patent Classification (CPC):
**H03M 13/29; G06N 3/045; G06N 3/0455;**
**G06N 3/0464; G06N 3/08; G06N 3/084;**
**H03M 13/3792; H03M 13/6597; H04L 1/0064;**
H03M 13/09; H03M 13/13; H03M 13/21;
H03M 13/451; H03M 13/611

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **15.04.2024   US 202463634123 P**
**14.04.2025   US 202519178476**

(71) Applicant: **Samsung Electronics Co., Ltd.**
**Suwon-si, Gyeonggi-do 16677 (KR)**

(72) Inventors:
• **SABER, Hamid**
**San Jose, CA 95134 (US)**
• **BAE, Jung Hyun**
**San Jose, CA 95134 (US)**

(74) Representative: **Kuhnen & Wacker**
**Patent- und Rechtsanwaltsbüro PartG mbB**
**Prinz-Ludwig-Straße 40A**
**85354 Freising (DE)**

(54) **METHODS AND DEVICES FOR A DEEP LEARNING BASED POLAR CODING SCHEME**

(57)   Methods and devices are provided in which a processor of an electronic device encodes segments of a binary message word into real-valued outer codewords using corresponding non-linear neural network, NN, outer encoding processes. The processor combines the real-valued outer codewords using a real-field polarization operation to generate a codeword for the binary message word.

FIG. 5

## Description

### TECHNICAL FIELD

The disclosure generally relates to channel coding schemes in wireless communication systems. More particularly, the subject matter disclosed herein relates to improvements to a deep learning based polar coding scheme.

### SUMMARY

Reliable transmission over noisy channels has been an active research area for decades, with channel coding serving as the primary tool to achieve such reliability by transforming input data into higher dimensional representations. Channel coding schemes, such as those based on the additive white Gaussian noise (AWGN) channel, rely on well-defined mathematical models and analytical tools to design encoder-decoder pairs that optimize performance metrics like block error rate (BLER) and bit error rate (BER). Despite theoretical results, practical code designs have traditionally depended on human ingenuity and analytic techniques to optimize parameters such as pairwise distance properties under decoders like maximum a posteriori (MAP) or successive cancellation (SC).

To solve this problem, researchers have pursued several avenues for designing robust codes. Some methods involve constructing (N,K) channel codes where binary message words are mapped to real-valued codewords using carefully designed encoders. Turbo codes and polar codes exemplify approaches that tailor encoder-decoder structures to specific channel models. Deep learning (DL) frameworks have been employed to automate the design of encoder and decoder networks, resulting in channel auto-encoders (AEs) that learn to optimize performance directly from channel transmission data. Turbo-AEs and neural network (NN)-assisted polar decoding may mimic coding schemes within a deep learning context.

One issue with the above approach is that, while DL-based channel AEs have shown potential, they often rely on linear or rigid structures that do not fully capture the nonlinearities inherent in many channel environments. Specifically, the incorporation of NN operations into polar decoding has not sufficiently generalized the concept of concatenated coding, nor has it effectively integrated non-linear learnable components into both the encoding and decoding stages. As a result, the performance under more complex decoding strategies, such as successive cancellation list (SCL) decoding, remains suboptimal.

To overcome these issues, systems and methods are described herein for a generalized concatenated polar AE that integrates deep learning-based techniques with the structural insights of polar codes. A novel encoder architecture is provided that incorporates non-linear NN outer encoders universally across various information/frozen set patterns, a non-linear NN polarization kernel, and non-linear NN blocks for bit-channel output computation. On the decoding side, the design includes dedicated NN decoding blocks for each outer code along with specialized loss functions to train the AE under list decoding scenarios, thus mimicking and extending the principles of polar code design.

The above approaches improve on previous methods because they enable a fully learnable, non-linear polarization-based encoding and decoding scheme that generalizes polar codes. By leveraging deep learning to optimize every component of the encoding-decoding process, the proposed methods may achieve performance gains over traditional schemes, particularly under SC and list decoding. The disclosure not only automates the design process for channel codes but also broadens the scope of applicability to channels that are either too complex for conventional analysis or lack a well-defined analytical model, paving the way for more robust and adaptable communication systems.

In an embodiment, a method is provided in which a processor of an electronic device encodes segments of a binary message word into real-valued outer codewords using corresponding non-linear NN outer encoding processes. The processor combines the real-valued outer codewords using a real-field polarization operation to generate a codeword for the binary message word.

In an embodiment, a method is provided in which a processor of an electronic device generates vectors from corresponding matrices of a codeword using real-field polarization operations. The processor decodes the vectors using corresponding non-linear NN outer decoding processes to generate segments of a binary message word. The processor determines a binary message word corresponding to the codeword from the segments.

In an embodiment, an electronic device is provided that includes a transmitter, a processor, and a non-transitory computer readable storage medium storing instructions. When executed, the instructions cause the processor to encode segments of a binary message word into real-valued outer codewords using corresponding non-linear NN outer encoding processes, and combine the real-valued outer codewords using a real-field polarization operation to generate a codeword for the binary message word.

In an embodiment, an electronic device is provided that includes a receiver, a processor, and a non-transitory computer readable storage medium storing instructions. When executed, the instructions cause the processor to generate vectors from corresponding matrices of a codeword using real-field polarization operations, decode the vectors using corresponding non-linear NN outer decoding processes to generate segments of a binary message word, and determine a binary message word corresponding to the codeword from the segments.

## BRIEF DESCRIPTION OF THE DRAWING

In the following section, the aspects of the subject matter disclosed herein will be described with reference to exemplary embodiments illustrated in the figures, in which:

FIG. 1 is a diagram illustrating a communication system, according to an embodiment;
FIG. 2 is a diagram illustrating an AE, according to an embodiment;
FIG. 3 is a diagram illustrating a general channel AE with list decoding, according to an embodiment;
FIG. 4 is a diagram illustrating a decoding process, according to an embodiment;
FIG. 5 is a diagram illustrating an encoding process of a gcc-polar-AE with four outer codes, according to an embodiment;
FIG. 6 is a diagram illustrating an SC decoding process of gcc-polar-AE with four outer codes, according to an embodiment;
FIG. 7 is a diagram illustrating an SCL encoding process of polar-AE for $M_{out}$ outer codes, according to an embodiment;
FIG. 8 is a diagram illustrating an SCL decoding process of polar-AE for $M_{out}$ outer codes, according to an embodiment;
FIG. 9 is a diagram illustrating an encoder block of a transformer (TF) network, according to an embodiment;
FIG. 10 is a flowchart illustrating a method of generating a codeword with a polar AE, according to an embodiment;
FIG. 11 is a flowchart illustrating a method of decoding a codeword with a polar AE, according to an embodiment; and
FIG. 12 is a block diagram of an electronic device in a network environment, according to an embodiment.

## DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "module" refers to any combination of software, firmware and/or hardware configured to provide the functionality described herein in connection with a module. For example, software may be embodied as a software package, code and/or instruction set or instructions, and the term "hardware," as used in any implementation described herein, may include, for example, singly or in any combination, an assembly, hardwired circuitry, programmable circuitry, state machine circuitry, and/or firmware that stores instructions executed by programmable circuitry. The modules may, collectively or individually, be embodied as circuitry that forms part of a larger system, for example, but not limited to, an integrated circuit (IC), system on-a-chip (SoC), an assembly, and so forth.

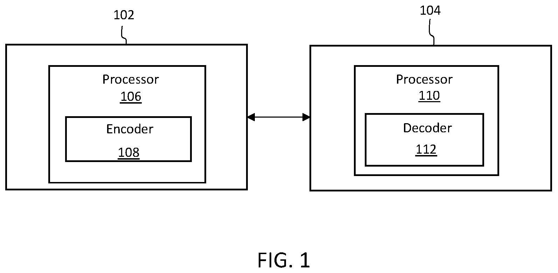

FIG. 1 is a diagram illustrating a communication system, according to an embodiment.

In the architecture illustrated in FIG. 1, a transmitting device 102 includes a first processor 106 including an encoder module 108. The transmitting device 102 is in communication with a receiving device 104, which includes a second processor 110 including a decoder module 112. Through the encoder module 108 the processor 106 may encode messages (or message-words) into codewords that are sent from the transmitting device 102 to the receiving device 104. Through the decoder module 112 the processor 110 may decode received codewords into messages (or message-words) at the receiving device 104.

While the present disclosure may reference specific encoders and decoders for illustrative purposes, it is understood that these functions can be implemented by a processor executing one or more encoding and/or decoding operations, and are not limited to dedicated hardware components.

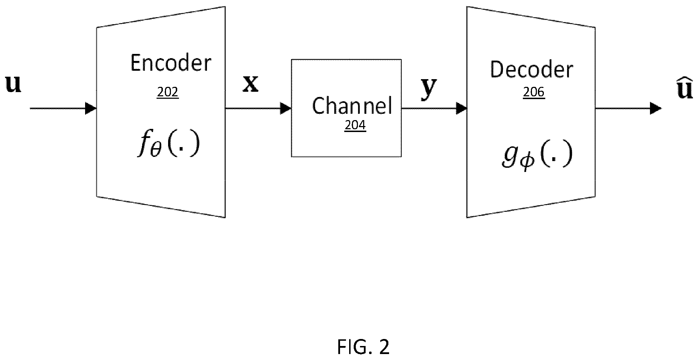

FIG. 2 is a diagram illustrating an AE, according to an embodiment.

Referring to FIG. 2, a message word of $K$ bits may be formed as u = $[u_1,...,u_K]$, where $u_i$ takes binary values from {0, 1}. The message word may be encoded using an encoder NN 202 with an encoding function $f_\theta(.)$ to obtain real-valued codeword x = $[x_1,...,x_N]$ = $f_\theta(u)$, where $\theta$ denotes the weights of the encoder neural network and N denotes the code length.

A power normalization block may be applied to x to give a codeword with unit power code symbols, $\sum_{i=1}^{N} x_i^2 = N$. The codeword x may be transmitted over a channel 204.

The channel 204 may take the codeword x as input and may output a noisy version $y = [y_1,...,y_N]$, where the $y_i$ take real values. Having an information-theoretically defined channel model is not necessary, but if there is such a model, it may be defined as a vector channel with transition probability density function (pdf) $W_N(y|x)$. A widely used channel among researchers for code design is an AWGN channel for which the output $y_i = x_i + w_i$, where $w_i$ is Gaussian random variable with zero mean and variance $\sigma^2$. For AWGN channel $W_N(y|x) = \prod_{i=1}^{N} W(y_i|x_i)$, which is expressed as Equation (1) below:

$$W(y|x) = \frac{1}{\sigma\sqrt{2\pi}} \exp\left(-\frac{(y-x)^2}{2\sigma^2}\right).$$

$$\ldots(1)$$

A decoder network 206 may receive the channel output vector y and may apply a decoding function $g_\phi(.)$ to give the decoded message word û = $[û_1,...,û_K]$ = $g_\phi(y)$, where the $\phi$ denotes the weights of the decoder neural network. The encoder and decoder networks together form an AE. The goal is to minimize the BLER or BER for different levels of impairment (e.g., signal-to-noise ratio (SNR) defined as $10 \log \frac{1}{\sigma^2}$ for the AWGN channel).

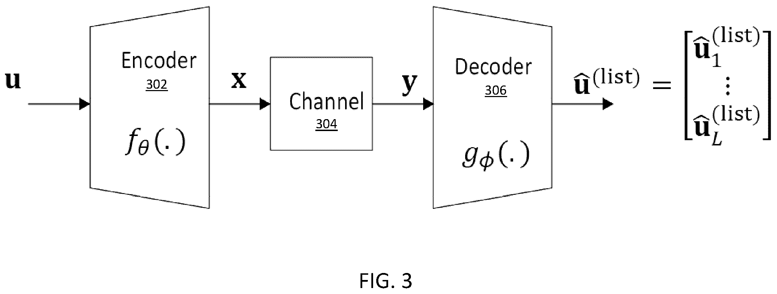

FIG. 3 is a diagram illustrating a general channel AE with list decoding, according to an embodiment. Specifically, the general channel AE may be defined as an AE that outputs a list of $L$ candidates where $L$ is the list size.

Referring to FIG. 3, an encoder 302, a channel 304 and a decoder 306 function in a manner similar to that described above with respect to FIG. 2. Since, in the testing phase, the decoder outputs a single candidate û, there is a selection process where a single candidate is chosen from the list. A genie-aided (GA) decoder outputs the single candidate as shown below in Equation (2).

$$\widehat{\mathbf{u}} = \begin{cases} \mathbf{u} & if \ \widehat{\mathbf{u}}_j^{(\text{list})} = \mathbf{u} \ for \ any \ j \in \{1, \dots, L\} \\ \widehat{\mathbf{u}}_r^{(\text{list})} & otherwise \end{cases}$$

$$\dots (2)$$

In Equation (2), r is a random number chosen uniformly from 1 to $L$. During the training phase, the value of each element of vectors in the output list $\hat{u}^{(\text{list})}$ is made to take a real number between zero and one, for example, by passing through a Sigmoid activation. In the testing phase the outputs are rounded to the nearest integer to give binary values. It may also be also possible to select a single candidate by replacing the genie with cyclic redundancy check (CRC).

For an AE, a number of loss functions, such as mean square error (MSE) and binary cross entropy (BCE), may be more suitable for BER optimization. Although BER optimization indirectly optimizes the BLER, finding BLER-specific loss functions with efficient training complexity remains an open problem. A loss function for minimizing BER is the BCE loss, which is defined as set forth in Equation (3) below:

$$\rho\left(\widehat{\mathbf{u}}, \mathbf{u}\right) = \frac{1}{K} \sum_{i=1}^{K} \text{bce}(\hat{u}_i, u_i)$$

$$\dots (3)$$

where $\text{bce}(\hat{u}_i, u_i) = -u_i \log \hat{u}_i - (1 - u_i) \log(1 - \hat{u}_i)$, and $K$ represents the message word length, i.e., the number of information/message bits which will be encoded by the encoder to provide N code symbols.

A loss function to minimize the BLER may reflect the event in which at least one bit is decoded in error. An example of such a function is the one that minimizes the maximum of positional BERs (i.e., BER for each bit index, over all positions/indices), as shown in Equation (4) below.

$$\rho\left(\widehat{\mathbf{u}}, \mathbf{u}\right) = \max_{i \in \{1, \dots, K\}} \text{bce}(\hat{u}_i, u_i)$$

$$\dots (4)$$

With GA list decoding, the challenge for defining a loss function which is tailored to the GA decoding of the channel AE with list decoding may lie in how to mathematically model the genie operation. The genie operation may be a processing block that takes the list of candidates as well as the transmitted message word and outputs a single candidate depending on the presence of the message word in the list. The condition for checking this presence may involve rounding the candidate message words in the list to take binary values and then comparing them to the transmitted word. This operation may a) introduce zero derivative in the back propagation, and b) additionally may complicate it due to the comparisons. To tackle this problem, a modified loss function may be provided that reflects how "close" the output list is to the message word without involving the precise genie operation. The loss function may take small values when the message word is "close" to any candidate in the list and is defined as set forth in Equation (5) below:

$$\text{loss}\left(\widehat{\mathbf{u}}^{(\text{list})}, \mathbf{u}\right) = \min_{l \in \{1, \dots, L\}} \rho\left(\widehat{\mathbf{u}}_l^{(\text{list})}, \mathbf{u}\right)$$

$$\dots (5)$$

where $\rho$ is a loss function used for $L = 1$, which takes two vectors $\hat{x} = [\hat{x}_1, \dots \hat{x}_K]$ and $x = [x_1, \dots, x_K]$ of length $K$. Two possibilities for this functions are set forth in Equations (6) and (7) below:

$$\rho\,(\hat{\mathbf{x}}, \mathbf{x})\ = \frac{1}{K}\sum_{i=1}^{K}\text{bce}(\hat{x}_i, x_i)$$

$$\dots (6)$$

$$\rho\,(\hat{\mathbf{x}}, \mathbf{x})\ = \max_{i\in\{1,\dots,K\}}\text{bce}(\hat{x}_i, x_i)$$

$$\dots (7)$$

With CA decoding and a $Z$ bit CRC generated by a polynomial $g(x) = g_0 + g_1 x + \dots + g_Z x^Z$, a word of $K$ - $Z$ bits may be generated and may be passed to the CRC calculator to generate $Z$ CRC bits. The CRC bits may be appended to the end of the message word to give the length-$K$ vector u as the encoder input. At the decoder side, each candidate in the list may be checked for passing CRC equations. Among the candidates that pass the CRC, one may be randomly chosen as the final output of the decoder.

To train an AE with under CA list decoding, the CRC bits may be considered information bits. In other words, the correlation between the bits of u may not be considered to minimize the loss function. The reason is similar to those which led to employing the proposed loss function and avoiding the precise genie operation. Similarly, checking CRC involves binary Galois field operations which complicates the loss function and training. Therefore, the proposed loss function may be used for training both GA and CA decoding.

Polar coding may be based on the binary polarization kernel, as shown in Equation (8) below:

$$\mathbf{F} = \begin{bmatrix} 1 & 0 \\ 1 & 1 \end{bmatrix}$$

$$\dots (8)$$

The encoding of a polar code of length $(N = 2^n, K)$ and information set indices $\mathcal{A} \subset \{1, \dots, N\}$ with $|\mathcal{A}| = K$ may be defined recursively, as set forth in Equations (9), (10), and (11) below:

$$c_1^N = f_{enc}(u_1^K, \mathcal{A}, N) = [a_1 + a_2, a_2] = [a_1, a_2] \times \begin{bmatrix} I_{N/2} & 0_{N/2} \\ I_{N/2} & I_{N/2} \end{bmatrix} = [a_1, a_2] \times F \otimes I_{N/2},$$

$$\dots (9)$$

where

$$a_1 = f_{enc}\left(u_1^{K_1}, \mathcal{A}_1, \frac{N}{2}\right)$$

$$\dots (10)$$

and

$$a_2 = f_{enc}\left(u_{K_1+1}^K, \mathcal{A}_2, \frac{N}{2}\right).$$

$$\dots (11)$$

$u_1^{K_1}$ may include the first $K_1$ elements of $u_1^K$, and $u_{K_1+1}^K$ may include the last K - $K_1$ elements. $K_1$ may be defined as the cardinality of $\mathcal{A}_1$. The set $\mathcal{A}_1$ may be the subset of $\mathcal{A}$ that consists of all elements which are smaller or equal to $N/2$ and set $\mathcal{A}_2 =$

$$\left\{ i - \frac{N}{2} \,\middle|\, i \in \mathcal{A} \right\}.$$

For length $N = 1$, if $\mathcal{A} = \{\}$, the output may be c = 0, otherwise c = $f_{enc}(u, \mathcal{A} = \{1\}, 1) = u$.

The recursive encoding function may be defined by the kernel operation (1). In general, one can replace the kernel operation with arbitrary nonlinear function $\kappa(.)$, as shown in Equation (12) below:

$$c_1^2 = \kappa(u_1^2)$$

$$\ldots(12)$$

where a length-2 vector may be mapped it to another length-2 vector to obtain a neural polar encoder.

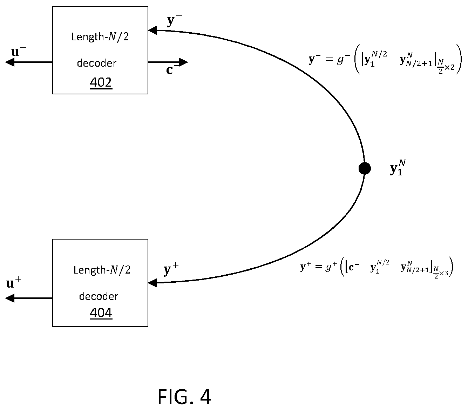

FIG. 4 is a diagram illustrating a decoding process, according to an embodiment.

Referring to FIG. 4, decoding of a neural polar code of length $N$ may also be performed recursively based on the decoding results of the two smaller neural polar codes of length $N/2$. Two bit-channel calculation functions $g^-: \mathcal{R}^2 \to \mathcal{R}$ and $g^+: \mathcal{R}^3 \to \mathcal{R}$ may be used to obtain the input to the decoders 402 and 404 of the length-$N/2$ codes form that of the length-$N$ code, where $\mathcal{R}$ is the set of real numbers. Denoting the received codeword of the length-$N$ code as a column vector $y_1^N$ may result in Equation (13) below:

$$y_{\frac{N}{2} \times 1}^- = g^- \left( \left[ y_1^{N/2} \quad y_{N/2+1}^N \right]_{\frac{N}{2} \times 2} \right)$$

$$\ldots(13)$$

where the function $g^-$ may operate at each row of the input matrix to generate a scalar output. $y^-$ may be used to decode the first length-$N/2$ code. The decoded codeword may be c$^-$. The output of this decoder 402 may be a decoded message word u$^-$, which may then encoded to obtain the corresponding codeword c$^-$. Next, c$^-$ and $y_1^N$ may be input to the second bit-channel calculation function $g^+$ to calculate the input y$^+$ to the second length-$N/2$ code, as shown in Equation (14) below:

$$y_{\frac{N}{2} \times 1}^+ = g^+ \left( \left[ c^- \quad y_1^{N/2} \quad y_{N/2+1}^N \right]_{\frac{N}{2} \times 3} \right)$$

$$\ldots(14)$$

where the function $g^+$ may operates at each row of the input matrix to generate a scalar output. A successive cancellation decoding of the neural polar code (a polar auto-encoder) is described with encoding kernel $\kappa$, bit-channel calculation functions $g^-$ and $g^+$. A polar-AE may be defined by these encoding and decoding operations using ($\kappa$, $g^-$, $g^+$) which can be implemented via neural networks.

Table 1 summarizes a polar-AE according to an embodiment and compares the polar AE with a polar encoding and decoding.

Table 1

| Item | Polar code | Polar-AE |
|---|---|---|
| Polarization kernel/transform | $c_1^2 = u_1^2 . \mathbf{F}$ <br> $\mathbf{F} = \begin{bmatrix} 1 & 0 \\ 1 & 1 \end{bmatrix}$ <br> with | $c_1^2 = \kappa(u_1^2)$ $\kappa$ is implemented by an NN with learnable weights |

(continued)

| Item | Polar code | Polar-AE |
|---|---|---|
| Degraded bit-channel $W^-$ | $\lambda^{(1)} = \lambda_1 \boxplus \lambda_2$ $= 2\tanh^{-1}\left(\tanh\dfrac{\lambda_1}{2}\cdot\tanh\dfrac{\lambda_2}{2}\right)$ | $\lambda^{(1)} = g^-(\lambda_1, \lambda_2)$ $g^-$ is implemented via NN with learnable weights and maps a length-2 input vector to a scalar |
| Degraded bit-channel $W^+$ | $\lambda^{(2)} = (1 - 2u_1)\lambda_1 + \lambda_2$ | $\lambda^{(2)} = g^+(u_1, \lambda_1, \lambda_2)$ $g^+$ is implemented via NN with learnable weights and maps a length-3 input vector to a scalar |

In Table 1, $\lambda$ is a dummy variable. In case of a polar code, it represents LLR and in case of polar-AE with real-valued code bits, it represents the received value of the code symbols at the output of channel. The channel output values are used in place of them and the output of these operators are used as inputs later in the decoding procedure, recursively.

In a different approach, the polar transformation matrix for length $N = 2^n$ may be written as Equation (15) below:

$$G_N = F^{\otimes n} = F^{\otimes n - n_{out}} \otimes F^{\otimes n_{out}}.$$

$$\dots(15)$$

$2^{n-n_{out}}$ component codes, referred to as outer codes, may encode the corresponding sub-blocks of the length- N message words, to get the $2^{n-n_{out}}$ outer codewords of length $N_{out} = 2^{n_{out}}$. These outer code words may then be encoded using another component code, referred to as inner code or polarization kernel, of length $N_{in} = 2^{n-n_{out}}$ which operates position-wise on the outer codewords. The general idea beyond Scheme 2 is to implement the outer codes and the inner code/polarization kernel via a neural network.

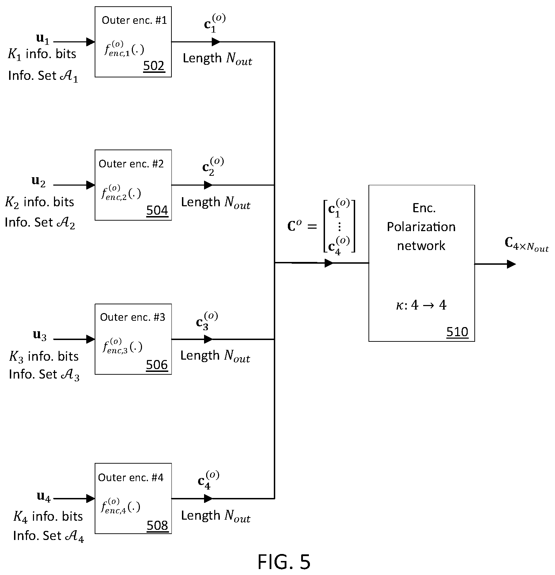

FIG. 5 is a diagram illustrating an encoder of a gcc-polar-AE with four outer codes, according to an embodiment. More specifically, FIG. 5 illustrates five neural networks that implement the outer encoders and the polarization kernel.

Referring to FIG. 5, the encoder of a polar-AE based on Scheme 2 may consist of $M_{out}$ outer codes of length $N_{out} = 2^{n_{out}}$ for a code length $N = M_{out} \cdot N_{out}$. To encode a message word u of $K$ bits, $M_{out}$ outer message words of length $N_{out}$, denoted as $u_1, ..., u_{M_{out}}$, may be constructed. The outer message word $u_i$ has $K_i$ information bits and $N_{out} - K_i$ frozen bits for i $= 1, ..., M_{out}$. $K = \sum_{i=1}^{M_{out}} K_i$. The information bits of the i-th outer encoder may be placed on the indices of $u_i$ according to a given information set $\mathcal{A}_i$. The $u_i$ may be transformed to the outer codewords $c_i^{(o)} = [c_{i,1}^{(o)}, ..., c_{i,N_{out}}^{(o)}]$. For example, as shown in FIG. 5, a first outer encoder 502 transforms $u_1$ into $c_1^{(o)}$, a second outer encoder 504 transforms $u_2$ into $c_2^{(o)}$, a third outer encoder 506 transforms $u_3$ into $c_3^{(o)}$, and a fourth outer encoder 508 transforms $u_4$ into $c_4^{(o)}$.

After outer encoding, a polarization kernel 510 may be applied. The outer codewords may be written in a $M_{out} \times N_{out}$ matrix

$$C^o = \begin{bmatrix} c_1^{(o)} \\ \vdots \\ c_{M_{out}}^{(o)} \end{bmatrix}$$

row by row. The polarization kernel 510, may then take the matrix $C^o$ as the input argument and outputs another matrix of the same size C by operating on each column of the input matrix independently. The operation may be defined as a function that takes a vector of length $M_{out}$ and outputs another vector of length $M_{out}$. The matrix C may then be reshaped to a vector of length N by reading the rows of C starting from the first row. The result may then be normalized to have a unit code symbol power. This may be referred to as GCC, and polar-AE constructed according to Scheme 2 may be referred to as gcc-polar-AE.

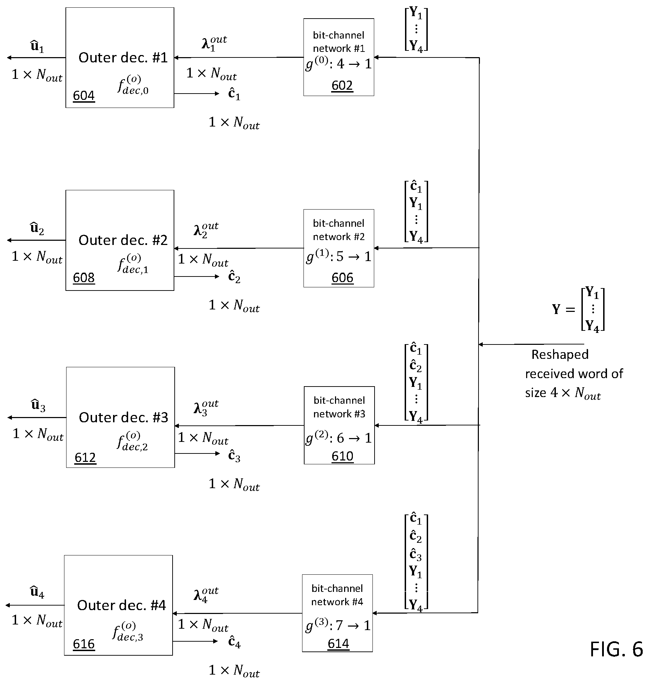

FIG. 6 is a diagram illustrating an SC decoder of gcc-polar-AE with four outer codes, according to an embodiment.

Referring to FIG. 6, the decoder side of the polar-AE may be implemented to mimic the SC decoding. The decoder side may take a received word Y corresponding to the transmitted codeword C, and may output a decoded message word û. The decoder block may include of $M_{out}$ outer decoders, and $M_{out}$ decoder polarization networks, which mimic the bit-channel LLR calculation blocks in the polar decoding. For example, as shown in FIG. 6, the decoder block may include a first decoder polarization network 602 with a first outer decoder 604, a second decoder polarization network 606 with a second outer decoder 608, a third decoder polarization network 610 with a third outer decoder 612, and a fourth decoder polarization network 614 with a fourth outer decoder 616. The message word may be decoded sequentially from the first outer code to the last one.

The decoded message word at the output of the i-th decoder by $\hat{u}_i$ is of length $N_{out}$ and has $K_i$ info bits at the information set indices and $N_{out} - K_i$ frozen bits at the remaining indices. For example, with respect to FIG. 6, the first outer decoder 604 outputs $\hat{u}_1$, the second outer decoder 608 outputs $\hat{u}_2$, the third outer decoder 612 outputs $\hat{u}_3$, and the fourth outer decoder 616 outputs $\hat{u}_4$.

$\hat{c}_i$ is the outer codeword corresponding to the message word $\hat{u}_i$. $\hat{c}_i$ may be obtained by applying the i-th outer

$$Y_{M_{out} \times N_{out}} = \begin{bmatrix} Y_1 \\ \vdots \\ Y_{M_{out}} \end{bmatrix}$$

encoder block to $\hat{u}_i$ and has the same size as $\hat{u}_i$. To mimic the polar decoding, the received word

and the decoded outer codewords $\hat{c}_1, ..., \hat{c}_{i-1}$, may be concatenated to each other to form a matrix of size $(M_{out} + i - 1) \times N_{out}$

as $\begin{bmatrix} \hat{c}_1 \\ \vdots \\ \hat{c}_{i-1} \\ Y \end{bmatrix}$. This matrix may be the input of the i-th decoder polarization network which outputs a vector of length $N_{out}$. The polarization network #i may take a vector of length $M_{out} + i - 1$ and may output a scalar. The output of the i-th polarization network may be the input of the i-th outer decoder which outputs the i-th decoded message word $\hat{u}_i$. The final decoded

message word may be $\hat{u} = \begin{bmatrix} \hat{u}_1 \\ \vdots \\ \hat{u}_{M_{out}} \end{bmatrix}$.

SCL decoding may be implemented by applying the aforementioned blocks to a list of candidates independently. In that case, every decoded message or codeword may be a list of $L$ candiadtes, where $L$ is the list size. This version of SCL decoding is different from polar decoding in the sense that each outer decoder in the polar decoding generates an expanded list and there is a pruning procedure involved based on path metrics. $L$ may be considered independent parallel SC decoders as an SCL decoder of list size $L$. The output of the SCL decoder may be denoted by $\hat{u}^{(list)}$, which is of size $N \times L$ where each column is a decoded message word candidate. Rows with indices corresponding to the frozen set are zeros.

Table 2 summarizes the polar-AE according to another embodiment and compares the polar-AE with polar encoding and decoding. The polar-AE has $M_{out} = 2^{n-n_{out}}$ outer encoders of length $N_{out} = 2^{n_{out}}$.

Table 2

| Item | Polar code | Polar-AE (GCC-polar-AE) |
|---|---|---|
| Outer encoder | $$\mathbf{c}_i^{(o)} = \mathbf{u}_i \cdot \mathbf{F}^{n_{out}}$$ $$\mathbf{F} = \begin{bmatrix} 1 & 0 \\ 1 & 1 \end{bmatrix}$$ with | $\mathbf{c}_i^{(o)} = f_{enc,i}^{(o)}(\mathbf{u}_i)$  $f_{enc,i}^{(o)}: N_{out} \to N_{out}$ is implemented by an NN with learnable weights for $i = 1, ..., M_{out}$ |
| Inner encoder/polarization kernel | Length-$M_{out}$ linear transform via matrix $\mathbf{F}^{n-n_{out}}$ | Length-$M_{out}$ linear transform $\kappa(.)$ Implemented via NN: $\kappa: M_{out} \to M_{out}$ |
| Bit-channel function at decoder | $\lambda^{(i)}$ is obtained via SC decoding of a length $M_{out}$ polar code, for $i = 1, ..., M_{out}$ | for $i = 1, ..., M_{out}$ $\lambda^{(i)} = g^{(i)}(u_1^{i-1}, \lambda_1, ..., \lambda_{M_{out}})$  $g^{(i)}$ is implemented via NN with learnable weights and maps a length-$(M_{out} + i - 1)$ input vector to a scalar |

(continued)

| Item | Polar code | Polar-AE (GCC-polar-AE) |
|---|---|---|
| Outer decoder | SC/SCL decoding of length $N_{out}$ polar code for $i = 1, ...,M_{out}$ | Decoding of outer code #i with function $f_{dec,i}^{(o)}(.)\, i = 1, ..., M_{out}$. $f_{dec,i}^{(o)}(.)$ maps length-$N_{out}$ LLR vector to a length-$N_{out}$ decoded word with $K_i$ information and $N_{out} - K_i$ frozen bits and is implemented via NN. |

To have an SCL decoder that mimics list expansion and pruning, there may be a list expansion factor $\alpha_{expand}$ and the outer decoders may output $L_{expand} = \alpha_{expand}.L$ candidates instead of $L$ candidates. This is equivalent to generating $\alpha$ child paths at the output of decoder number i from each mother path at the output of decoder number i - 1. A pruning network

$$\begin{bmatrix} \hat{\mathbf{u}}_1 \\ \vdots \\ \hat{\mathbf{u}}_i \end{bmatrix}_{iN_{out} \times L_{expand}}$$

may then be used to prune the expanded list to L list members (L columns).

To obtain the decoded outer codeword $\hat{c}_i$ from decoded message word $\hat{u}_i$, which takes values between 0 and 1, the message word may be rounded to take binary values and then encoded. Rounding the decoded message words may improve the performance of the polar-AE.

If list expansion and pruning are not utilized, the polar-AE may not have to perform path metric sorting, which is generally undesirable due to its negative impacts on the decoding latency. Accordingly, this may be an advantage of utilizing polar-AE over the SCL decoder of polar codes.

Finding the $M \times M$ function to combine the outputs of the $M$ outer encoders may be difficult for the NN, so one approach is to applying the $M \times M$ polarization kernel recursively via a 2 by 2 polarization kernel that is implemented by a neural network. The kernel function is shown below in Equation (16):

$$[c_1, c_2] = \kappa(u_1, u_2).$$

$$\ldots(16)$$

Compared to Scheme 2, the encoding polarization network in Scheme 3, may be implemented by recursive application of $\kappa(.)$ in $n - n_{out}$ polarization steps.

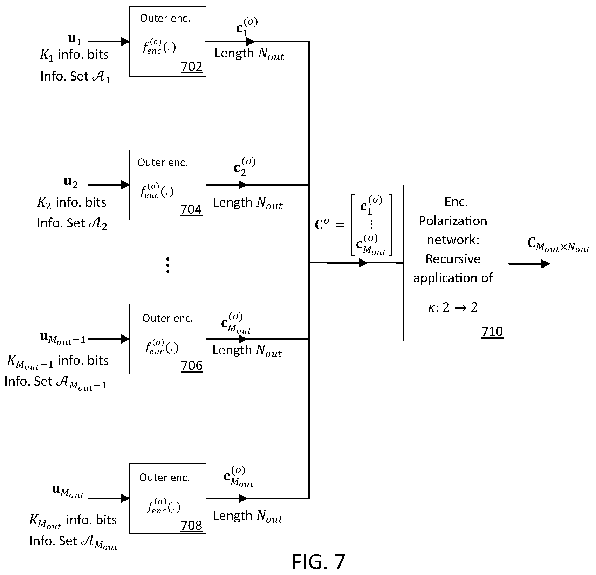

FIG. 7 is a diagram illustrating an SCL encoder of polar-AE for $M_{out}$ outer codes, according to an embodiment.

Referring to FIG. 7, the outer encoders 702, 704, 706, and 708 may be universally implemented across the outer code indices and information sets. This is because, once the $K_i$ information bits are rate profiled to a length- $N_{out}$ vector $\mathbf{u}_i$, the mapping from $\mathbf{u}_i$ to $\tilde{\mathbf{c}}_i^{(o)}$ has at least a good universal solution given by the linear transform $\mathbf{F}^{n_{out}}$. Therefore, in this scheme it may be assumed that all outer encoder functions are identical across the outer code indices. That is,

$$\mathbf{c}_i^{(o)} = f_{enc}^{(o)}(\mathbf{u}_i) \text{ for } i = 1, ..., M_{out}.$$

With $M_{out}$ outer encoders, the $M_{out}$ outer codewords may be processed by recursive application of $\kappa(.)$ to the codewords in $m_{out}$ steps of polarizations, at a polarization kernel 710.

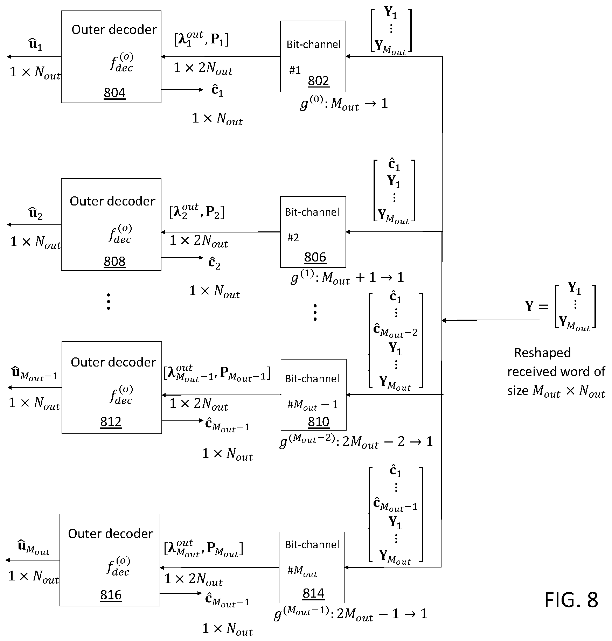

FIG. 8 is a diagram illustrating an SCL decoder of polar-AE for $M_{out}$ outer codes, according to an embodiment.

Referring to FIG. 8, decoding of this scheme is similar to Scheme 2 shown with respect to FIG. 6, with one difference. For example, as shown in FIG. 8, the decoder block may include a first decoder polarization network 802 with a first outer decoder 804, a second decoder polarization network 806 with a second outer decoder 808, a third decoder polarization network 810 with a third outer decoder 812, and a fourth decoder polarization network 814 with a fourth outer decoder 816. Similar to the encoder, it may be easier for the network to learn the $M_{out}$ bit-channel functions $g^{(i)}$, by learning two bit-channel functions $g^-: \mathcal{R}^2 \to \mathcal{R}$ and $g^+: \mathcal{R}^3 \to \mathcal{R}$, implemented via NN. Having the $g^-$ and $g^+$ functions, the output of each of function $g^{(i)}$ may be calculated by a SC decoding algorithm for a polar code of length $M_{out}$, but with the neural versions of $g^+(.)$ and $g^-(.)$.

For the outer decoders of FIG. 8, the SC decoder takes the LLR vector of length $N_{out}$ and outputs a decoded message word $\hat{u}_i$ of same length with zero values at the frozen bit indices. That is, the SC decoder may also take the information/frozen bits locations (e.g., in the form of a binary length-$K_i$ information bit pattern). Therefore, the SC decoder may be viewed as a function which takes two length-$N_{out}$ input vectors, one LLR vector and one information pattern vector, and outputs a length-$N_{out}$ decoded word. Such a function may be employed for each outer code index (i.e., is not outer-code specific). This approach may be used to attempt to mimic such a function in this scheme. An outer decoder may be a neural network which maps a length-$2N_{out}$ vector, obtained by concatenation of a length-$N_{out}$ LLR vector and a length-$N_{out}$ binary information pattern, to a length-$N_{out}$ decoded message words.

Table 3 summarizes the polar-AE according to another embodiment and compares the polar-AE with the polar encoding and decoding. The polar-AE has $M_{out} = 2^{n-n_{out}}$ outer encoders of length $N_{out} = 2^{n_{out}}$.

Table 3

| Item | Polar code | Polar-AE |
|---|---|---|
| Outer encoder | $$\mathbf{c}_i^{(o)} = \mathbf{u}_i . \mathbf{F}^{n_{out}}$$ $$\mathbf{F} = \begin{bmatrix} 1 & 0 \\ 1 & 1 \end{bmatrix}$$ with | $\mathbf{c}_i^{(o)} = f_{enc}^{(o)}(\mathbf{u}_i)$  $f_{enc}^{(o)}: N_{out} \to N_{out}$ is implemented by an NN with learnable weights |
| Inner encoder/polari-zation kernel | Length-$M_{out}$ linear transform via matrix $\mathbf{F}^{n\text{-}n_{out}}$ | Implemented via NN: $\kappa: 2 \to 2$. $\kappa(.)$ is applied recursively in $n - n_{out}$ polarization steps |
| Bit-channel function at decoder | $\lambda^{(i)}$ is obtained via SC decoding of a length $M_{out}$ polar code, for $i = 1, ..., M_{out}$ | for $i = 1, ..., M_{out}$ $\lambda^{(i)} = g^{(i)}(u_1^{i-1}, \lambda_1, ..., \lambda_{M_{out}})$ Output of the $g^{(i)}$ is calculated by a SC decoding algorithm for a polar code of length $M_{out}$, but with the neural bit-channels $g^+(.)$ and $g^-(.)$ $g^-: \mathcal{R}^2 \to \mathcal{R}$ and $g^+: \mathcal{R}^3 \to \mathcal{R}$ are two neural networks with learnable weights |
| Outer decoder | SC/SCL decoding of length $N_{out}$ polar code for $i = 1, ..., M_{out}$ | Decoding of outer code #$i$ with function $f_{dec}^{(o)}(.)$. $f_{dec}^{(o)}(.)$ maps a length-$2N_{out}$ (LLR vector, information pattern $P$) to a length-$N_{out}$ decoded word with $K_i$ information and $N_{out} - K_i$ frozen bits and is implemented via NN. |

To allow for soft transition between the polar coding and the deep learning based polar-AE in Scheme 3, a mixed operation may be introduced by calculating the output of each block by a weighted average of the polar coding operation and the neural network block. In particular, if a neural block maps x to y by a function y = $f_{NN}(x)$, and a polar coding block maps x to y by a function y = $f_{classical}(x)$, then the weighted average block maps x to y as shown in Equation (17) below:

$$\mathbf{y} = \alpha f_{NN}(\mathbf{x}) + (1 - \alpha)f_{classical}(\mathbf{x}) \text{ for } \alpha \in [0,1]$$

$$\ldots(17)$$

Polar-AE in Table 3 may be implemented with four weights ($\alpha_1, \alpha_2, \alpha_3, \alpha_4$), where $\alpha_1$ is the weight used for outer encoder, $\alpha_2$ is the weight used for the polarization network, $\alpha_3$ is the weight used for bit-channels at the decoder, and $\alpha_4$ is the weight used for outer decoder.

For example, a polar-AE with ($\alpha_1 = 0$, $\alpha_2 = 1$, $\alpha_3 = .5$, $\alpha_4 = 1$) may use outer encoders, a full-NN encoder polarization network, decoder bit-channels obtained as the mean of the output of a bit-channel block and a full-NN bit-channel block, and a full-NN outer decoder.

Different network types such as, for example, a multi-layer perceptron (MLP), a convolutional neural network (CNN), and a TF may be used to implement each of the blocks in the proposed schemes. Moreover, a "SameShape" CNN may be used, which means that the number of zero-padding is chosen such that the size of the output is the same as the input.

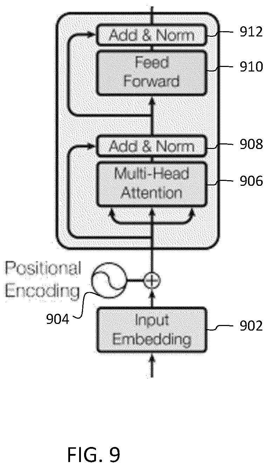

FIG. 9 is a diagram illustrating an encoder block of a TF network, according to an embodiment. TF blocks may

transform an $N \times 1$ sequence to another $N \times 1$ sequence.

Referring to FIG. 9, an embedding block 902 may be used to convert input tokens to a vector of dimension $d_{model}$ because 1) the tokens must be converted to real numbers to be processed by the network and 2) careful embedding should be designed to map the tokens with close meaning to close points in the $d_{model}$-dimensional space. With the Channel-AE design, each element of the input sequence may be mapped to a larger dimension $d_{model} > 1$, to allow for more flexibility for the network processing.

Embedding may be implemented via an NN that maps a scalar to a vector of length-$d_{model}$. The embedding network may be "common" or "index-specific" among different input indices. With common embedding, the same mapping may be used for every input index, while with index-specific embedding, different networks may be learned for different input indices.

Embedding networks may also be designed with different network types. For example, common MLP embedding may have one input feature and $d_{model}$ output features with certain number of layers, hidden layer size, and activation functions. Index-specific MLP may be the same as common MLP embedding but with different learnable parameters for different input indices. Common CNN may be SameShape CNN, which takes a length-$d_{model}$ vector and maps it to the same length. The input length-$d_{model}$ may be obtained by repeating the input scalar $d_{model}$ times. For index-specific MLP + common CNN, an index specific MLP may first be applied to obtain length-$d_{model}$ vector for each input index. Then the vector is passed to a SameShape CNN to get an output vector of length-$d_{model}$.

A positional encoding (PE) block 904 may provide information about the location of the tokens in the sequence. Without such a function, the attention block may output the same value for a permeated set of input tokens, which is not desired at least for the natural language processing application. Use of the attention block may be optional, and the PE block 904 is set forth in Equation (18) below:

$$PE(pos, 2i) = \sin\left(pos/1000^{2i/d_{model}}\right)$$
$$PE(pos, 2i + 1) = \cos\left(pos/1000^{2i/d_{model}}\right)$$

$$\ldots (18)$$

The TF block may employ a dot-product attention along with a scaling factor. An attention function is defined as shown below in Equation (19):

$$Attnetion(Q, K, V) = \text{softmax}\left(\frac{QK^T}{\sqrt{d_k}}\right)V$$

$$\ldots (19)$$

where V is the value sequence of size $N_v \times d_v$; K is the key sequence of size $N_k \times d_k$ where $N_k = N_v$ (i.e., pairs of (key,value)); Q is the query sequence of size $N_q \times d_k$; and the softmax function is applied per each row of $\frac{QK^T}{d_k}$ such that each row adds up to 1, for a weighted sum of the vector $V$.

An attention block may not have a learnable parameter. To add learnable parameters to it, three linear transforms may be introduced for query, key and value and denoted by $W_q$, $W_k$ and $W_v$. The sizes of $W_q$, $W_k$ and $W_v$ are $d_{model} \times d_k$, $d_{model} \times d_k$ and $d_{model} \times d_k$, respectively. An input sequence x of size $N \times d_{model}$ to the attention block is transformed to an output y of size $N \times d_{model}$ as shown in Table 4.

Table 4

| |
|---|
| 1) Make the query sequence: Q= $\mathbf{x}W_q$ |
| 2) Make the key sequence: K= $\mathbf{x}W_k$ |
| **3)** Make the value sequence: V = $\mathbf{x}W_v$ |
| **4)** **y** = *Attnetion(Q, K, V)* |
| Or, simply |
| **y** = *Attnetion($\mathbf{x}W_q$, $\mathbf{x}W_k$, $\mathbf{x}W_v$)* |

The attention block may transform the input sequence to contextualized output where the correlation between the input elements are captured at a given output index. Different input elements may be related to each other in different ways, so there may be multiple parallel attention layers to have multiple contextualized outputs, or a multi-head attention (MTH) block 906. The MTH 906 is multiple parallel attention blocks with different learnable parameters. The outputs of these blocks may be concatenated to each other and linearly combined to get one single output. In particular, an MTH block 906 with $h$ heads, may map an input sequence x of size $N \times d_{model}$ to an output y of size $N \times d_{model}$ as shown in Table 5.

Table 5

| |
|---|
| $\mathbf{y}$ = Concat($head_1$, ..., $head_h$)$W^o$ |
| Where |
| • $W^o$ is $d_{model} \times d_{model}$ learnable matrix |
| • $head_i = Attnetion(\mathbf{x}W_{q,i}, \mathbf{x}W_{k,i}, \mathbf{x}W_{v,i})$ where $W_q$, $W_k$ and $W_v$ are of size $d_{model} \times d_v$, $d_{model} \times d_k$ and $d_{model} \times$ $d_k$, respectively, and $d_k = d_v = \frac{d_{model}}{h}$ |

The input of the MTH block 906 may be added to its output and then passed through a first layer normalization block 908. The first layer normalization block 908 normalizes the input to be zero mean and unit variance, where the mean and variance may be calculated over the last dimension of the input. The first layer normalization block 908 may also include a learnable affine transform parameter. For example, a PyTorch layer normalization block may be defined to normalize the input x of size *(B, N, M)* over the last dimension. The output of this block is shown in Equation (20) below:

$$y = \frac{x - \mu}{\sqrt{\sigma + \epsilon}} * \gamma + \beta$$

$$\dots (20)$$

where $\mu$ and $\sigma$ are calculated across the M elements. y and $\beta$ are learnable parameters of length M, to allow the network to be able to work with non-zero and non-unit variance, if it prefers to do so.

A feed forward (FF) block 910 is a fully connect neural network (FCNN) and may be applied to each position separately and identically. The FF block may consist of two linear transformations with ReLU activation function in between, as shown in Equation (21) below:

$$FF(x) = \max(xW1 + b_1, 0)\, W_2 + b_2$$

$$\dots (21)$$

where the dimensions of $W_1$, $W_2$, $b_1$ and $b_2$ are $d_{model} \times d_{ff}$, $d_{ff} \times d_{model}$, $d_{ff} \times 1$ and $d_{model} \times 1$, respectively.

The input of the FF block 910 may be added to its output and then passed through a second layer normalization block 912.

The TF model may be employed at least for the decoder part of the polar-AE. The original TF model, which includes a TF encoder and a TF decoder, may match the SC decoding of polar code. Therefore, the TF model may be applied to perform SC decoding of polar code.

For a linear block code, bit-wise ML and block-wise ML decoders may be described as a sequence of Sum and ⊞ operations (Tanh-based for bit-wise ML and Min-based for block wise ML).

For a linear block code, block-wise ML may be derived from bit-wise ML by replacing the Tanh-based ⊞ with Min-based ⊞ operation.

For a linear block code, the bit-wise ML and block-wise ML decoders may be described as a sequence of variable and check node (tanh for bit-wise ML and min-sum for block wise ML) operations.

For a linear block code, block-wise ML may be derived from bit-wise ML by replacing the Tanh check node processor with the min-sum check node processor

For example, a linear block code may be provided with the generator and parity check matrices set forth in Equation (22) below:

$$G = \begin{bmatrix} 1 & 0 & 1 & 1 \\ 0 & 1 & 1 & 1 \end{bmatrix}$$
$$H = \begin{bmatrix} 1 & 1 & 1 & 0 \\ 1 & 1 & 0 & 1 \end{bmatrix}$$

$$\ldots(22)$$

From the four channel LLRs $\lambda_1, \ldots, \lambda_4$, the bit-wise ML may calculate the information bit LLRs as set forth in Equation (23) below:

$$\lambda^{(1)} = \lambda_1 + \lambda_2 \boxplus (\lambda_3 + \lambda_4)$$
$$\lambda^{(2)} = \lambda_2 + \lambda_1 \boxplus (\lambda_3 + \lambda_4)$$

$$\ldots(23)$$

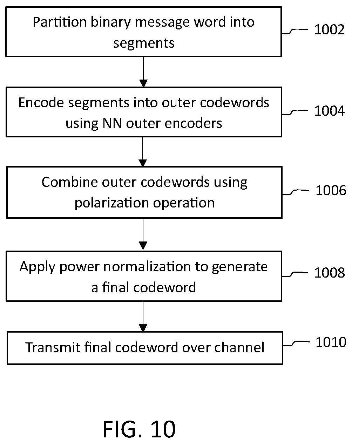

FIG. 10 is a flowchart illustrating a method of generating a codeword with a polar AE, according to an embodiment. At 1002, a processor of an electronic device may partition a binary message word into segments corresponding to outer codes via rate profiling. At 1004, the processor may encode the segments into real-valued outer codewords using corresponding non-linear NN outer encoders. The non-linear NN outer encoders may use the same NN weights. The non-linear NN outer encoders may include transformer networks having CNN-based input embedding. At 1006, the processor may combine the real-valued outer codewords using a real-field polarization operation to generate a codeword for the binary message word. At 1008, the processor may apply power normalization to the codeword to generate a final codeword. At 1010, the processor may transmit the final codeword over a channel to another electronic device.

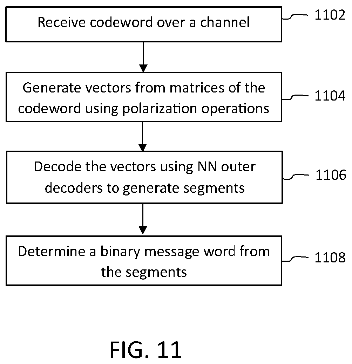

FIG. 11 is a flowchart illustrating a method of decoding a codeword with a polar AE, according to an embodiment. At 1102, a processor of an electronic device may receive the codeword over a channel from another electronic device. At 1104, the processor may generate vectors from corresponding matrices of the codeword using real-field polarization operations. At 1106, the processor may decode the vectors using corresponding non-linear NN outer decoders to generate segments of a binary message word. The vectors may be decoded sequentially and a matrix of the corresponding matrices may include any outer codewords corresponding to previously decoded vectors. The non-linear NN outer decoders may use the same NN weights. The non-linear NN outer decoders may include transformer networks having CNN-based input embedding. At 1108, the processor may determine a binary message word corresponding to the codeword from the segments.

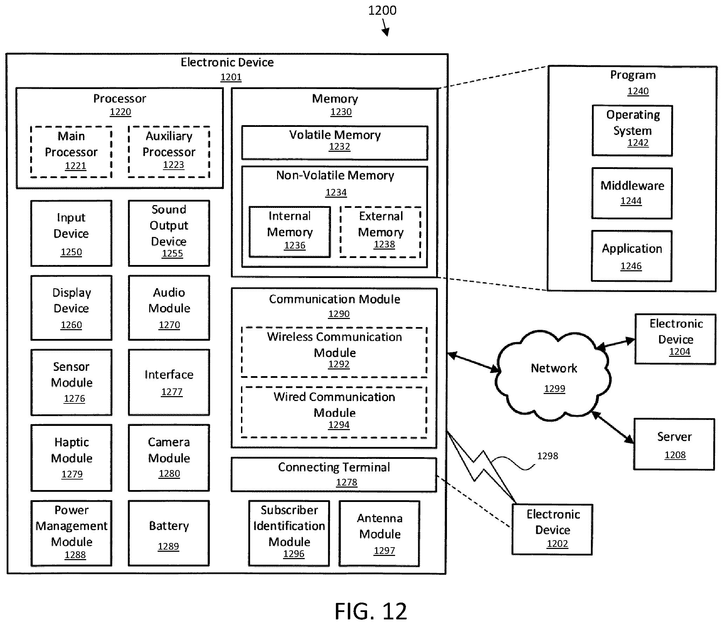

FIG. 12 is a block diagram of an electronic device in a network environment 1200, according to an embodiment.

Referring to FIG. 12, an electronic device 1201 in a network environment 1200 may communicate with an electronic device 1202 via a first network 1298 (e.g., a short-range wireless communication network), or an electronic device 1204 or a server 1208 via a second network 1299 (e.g., a long-range wireless communication network). The electronic device 1201 may communicate with the electronic device 1204 via the server 1208. The electronic device 1201 may include a processor 1220, a memory 1230, an input device 1250, a sound output device 1255, a display device 1260, an audio module 1270, a sensor module 1276, an interface 1277, a haptic module 1279, a camera module 1280, a power management module 1288, a battery 1289, a communication module 1290, a subscriber identification module (SIM) card 1296, or an antenna module 1297. In one embodiment, at least one (e.g., the display device 1260 or the camera module 1280) of the components may be omitted from the electronic device 1201, or one or more other components may be added to the electronic device 1201. Some of the components may be implemented as a single integrated circuit (IC). For example, the sensor module 1276 (e.g., a fingerprint sensor, an iris sensor, or an illuminance sensor) may be embedded in the display device 1260 (e.g., a display).

The processor 1220 may execute software (e.g., a program 1240) to control at least one other component (e.g., a hardware or a software component) of the electronic device 1201 coupled with the processor 1220 and may perform various data processing or computations.

As at least part of the data processing or computations, the processor 1220 may load a command or data received from another component (e.g., the sensor module 1276 or the communication module 1290) in volatile memory 1232, process the command or the data stored in the volatile memory 1232, and store resulting data in non-volatile memory 1234. The processor 1220 may include a main processor 1221 (e.g., a central processing unit (CPU) or an application processor (AP)), and an auxiliary processor 1223 (e.g., a graphics processing unit (GPU), an image signal processor (ISP), a sensor hub processor, or a communication processor (CP)) that is operable independently from, or in conjunction with, the main processor 1221. Additionally or alternatively, the auxiliary processor 1223 may be adapted to consume less power than the main processor 1221, or execute a particular function. The auxiliary processor 1223 may be implemented as being separate from, or a part of, the main processor 1221.

The auxiliary processor 1223 may control at least some of the functions or states related to at least one component (e.g., the display device 1260, the sensor module 1276, or the communication module 1290) among the components of the electronic device 1201, instead of the main processor 1221 while the main processor 1221 is in an inactive (e.g., sleep) state, or together with the main processor 1221 while the main processor 1221 is in an active state (e.g., executing an application). The auxiliary processor 1223 (e.g., an image signal processor or a communication processor) may be implemented as part of another component (e.g., the camera module 1280 or the communication module 1290) functionally related to the auxiliary processor 1223.

The memory 1230 may store various data used by at least one component (e.g., the processor 1220 or the sensor module 1276) of the electronic device 1201. The various data may include, for example, software (e.g., the program 1240) and input data or output data for a command related thereto. The memory 1230 may include the volatile memory 1232 or the non-volatile memory 1234. Non-volatile memory 1234 may include internal memory 1236 and/or external memory 1238.

The program 1240 may be stored in the memory 1230 as software, and may include, for example, an operating system (OS) 1242, middleware 1244, or an application 1246.

The input device 1250 may receive a command or data to be used by another component (e.g., the processor 1220) of the electronic device 1201, from the outside (e.g., a user) of the electronic device 1201. The input device 1250 may include, for example, a microphone, a mouse, or a keyboard.

The sound output device 1255 may output sound signals to the outside of the electronic device 1201. The sound output device 1255 may include, for example, a speaker or a receiver. The speaker may be used for general purposes, such as playing multimedia or recording, and the receiver may be used for receiving an incoming call. The receiver may be implemented as being separate from, or a part of, the speaker.

The display device 1260 may visually provide information to the outside (e.g., a user) of the electronic device 1201. The display device 1260 may include, for example, a display, a hologram device, or a projector and control circuitry to control a corresponding one of the display, hologram device, and projector. The display device 1260 may include touch circuitry adapted to detect a touch, or sensor circuitry (e.g., a pressure sensor) adapted to measure the intensity of force incurred by the touch.

The audio module 1270 may convert a sound into an electrical signal and vice versa. The audio module 1270 may obtain the sound via the input device 1250 or output the sound via the sound output device 1255 or a headphone of an external electronic device 1202 directly (e.g., wired) or wirelessly coupled with the electronic device 1201.

The sensor module 1276 may detect an operational state (e.g., power or temperature) of the electronic device 1201 or an environmental state (e.g., a state of a user) external to the electronic device 1201, and then generate an electrical signal or data value corresponding to the detected state. The sensor module 1276 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1277 may support one or more specified protocols to be used for the electronic device 1201 to be coupled with the external electronic device 1202 directly (e.g., wired) or wirelessly. The interface 1277 may include, for example, a high-definition multimedia interface (HDMI), a universal serial bus (USB) interface, a secure digital (SD) card interface, or an audio interface.

A connecting terminal 1278 may include a connector via which the electronic device 1201 may be physically connected with the external electronic device 1202. The connecting terminal 1278 may include, for example, an HDMI connector, a USB connector, an SD card connector, or an audio connector (e.g., a headphone connector).

The haptic module 1279 may convert an electrical signal into a mechanical stimulus (e.g., a vibration or a movement) or an electrical stimulus which may be recognized by a user via tactile sensation or kinesthetic sensation. The haptic module 1279 may include, for example, a motor, a piezoelectric element, or an electrical stimulator.

The camera module 1280 may capture a still image or moving images. The camera module 1280 may include one or more lenses, image sensors, image signal processors, or flashes. The power management module 1288 may manage power supplied to the electronic device 1201. The power management module 1288 may be implemented as at least part of, for example, a power management integrated circuit (PMIC).

The battery 1289 may supply power to at least one component of the electronic device 1201. The battery 1289 may include, for example, a primary cell which is not rechargeable, a secondary cell which is rechargeable, or a fuel cell.

The communication module 1290 may support establishing a direct (e.g., wired) communication channel or a wireless communication channel between the electronic device 1201 and the external electronic device (e.g., the electronic device 1202, the electronic device 1204, or the server 1208) and performing communication via the established communication channel. The communication module 1290 may include one or more communication processors that are operable independently from the processor 1220 (e.g., the AP) and supports a direct (e.g., wired) communication or a wireless communication. The communication module 1290 may include a wireless communication module 1292 (e.g., a cellular communication module, a short-range wireless communication module, or a global navigation satellite system (GNSS) communication module) or a wired communication module 1294 (e.g., a local area network (LAN) communication module or a power line communication (PLC) module). A corresponding one of these communication modules may communicate with the external electronic device via the first network 1298 (e.g., a short-range communication network, such as BLUETOOTH™, wireless-fidelity (Wi-Fi) direct, or a standard of the Infrared Data Association (IrDA)) or the second network 1299 (e.g., a long-range communication network, such as a cellular network, the Internet, or a computer network (e.g., LAN or wide area network (WAN)). These various types of communication modules may be implemented as a single component (e.g., a single IC), or may be implemented as multiple components (e.g., multiple ICs) that are separate from each other. The wireless communication module 1292 may identify and authenticate the electronic device 1201 in a communication network, such as the first network 1298 or the second network 1299, using subscriber information (e.g., international mobile subscriber identity (IMSI)) stored in the subscriber identification module 1296.

The antenna module 1297 may transmit or receive a signal or power to or from the outside (e.g., the external electronic device) of the electronic device 1201. The antenna module 1297 may include one or more antennas, and, therefrom, at least one antenna appropriate for a communication scheme used in the communication network, such as the first network 1298 or the second network 1299, may be selected, for example, by the communication module 1290 (e.g., the wireless communication module 1292). The signal or the power may then be transmitted or received between the communication module 1290 and the external electronic device via the selected at least one antenna.

Commands or data may be transmitted or received between the electronic device 1201 and the external electronic device 1204 via the server 1208 coupled with the second network 1299. Each of the electronic devices 1202 and 1204 may be a device of a same type as, or a different type, from the electronic device 1201. All or some of operations to be executed at the electronic device 1201 may be executed at one or more of the external electronic devices 1202, 1204, or 1208. For example, if the electronic device 1201 should perform a function or a service automatically, or in response to a request from a user or another device, the electronic device 1201, instead of, or in addition to, executing the function or the service, may request the one or more external electronic devices to perform at least part of the function or the service. The one or more external electronic devices receiving the request may perform the at least part of the function or the service requested, or an additional function or an additional service related to the request and transfer an outcome of the performing to the electronic device 1201. The electronic device 1201 may provide the outcome, with or without further processing of the outcome, as at least part of a reply to the request. To that end, a cloud computing, distributed computing, or client-server computing technology may be used, for example.

Embodiments of the subject matter and the operations described in this specification may be implemented in digital electronic circuitry, or in computer software, firmware, or hardware, including the structures disclosed in this specification and their structural equivalents, or in combinations of one or more of them. Embodiments of the subject matter described in this specification may be implemented as one or more computer programs, i.e., one or more modules of computer-program instructions, encoded on computer-storage medium for execution by, or to control the operation of data-processing apparatus. Alternatively or additionally, the program instructions can be encoded on an artificially-generated propagated signal, e.g., a machine-generated electrical, optical, or electromagnetic signal, which is generated to encode information for transmission to suitable receiver apparatus for execution by a data processing apparatus. A computer-storage medium can be, or be included in, a computer-readable storage device, a computer-readable storage substrate, a random or serial-access memory array or device, or a combination thereof. Moreover, while a computer-storage medium is not a propagated signal, a computer-storage medium may be a source or destination of computer-program instructions encoded in an artificially-generated propagated signal. The computer-storage medium can also be, or be included in, one or more separate physical components or media (e.g., multiple CDs, disks, or other storage devices). Additionally, the operations described in this specification may be implemented as operations performed by a data-processing apparatus on data stored on one or more computer-readable storage devices or received from other sources.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific exemplary teachings discussed above, but is instead defined by the following claims.

**Claims**

1. A method comprising:

   encoding, by a processor of an electronic device, segments of a binary message word into real-valued outer codewords using corresponding non-linear neural network, NN, outer encoding processes; and
   combining, by the processor, the real-valued outer codewords using a real-field polarization operation to generate a codeword for the binary message word.

2. The method of claim 1, further comprising:

   applying, by the processor, power normalization to the codeword to generate a final codeword; and
   transmitting, by the processor, the final codeword over a channel to another electronic device.

3. The method of claim 1 or 2, further comprising:
   partitioning, by the processor, the binary message word into the segments corresponding to outer codes via rate profiling.

4. The method of claim 3, wherein a length of the codeword for the binary message word is $N$, and the rate profiling is based on a length $N$ vector.

5. The method of any one of claims 1 to 4, wherein the non-linear NN outer encoding processes use same NN weights.

6. The method of any one of claims 1 to 5, wherein the non-linear NN outer encoding processes comprise transformer networks comprising convolutional neural network, CNN-, based input embedding.

7. The method of any one of claims 1 to 6, wherein the processor includes a polarization kernel, and
   wherein combining the real-valued outer codewords comprises mapping a first set of real values to a second set of real values.

8. The method of any one of claims 1 to 7, wherein a length of the codeword for the binary message word $N = 2^n$, and a number of the NN outer encoders $M = 2^m$.

9. The method of any one of claims 1 to 8, the processor includes a transformer, TF, encoder block.

10. The method of claim 9, wherein the TF encoder block includes an embedding block and an attention block.

11. The method of claim 10, wherein the attention block includes at least one of a multi-head attention, MTH, block, a normalization block, or a feed forward, FF, block.

12. A method comprising:

    generating, by a processor of an electronic device, vectors from corresponding matrices of a codeword using real-field polarization operations;

decoding, by the processor, the vectors using corresponding non-linear neural network, NN, outer decoding processes to generate segments of a binary message word; and

determine, by the processor, a binary message word corresponding to the codeword from the segments.

**13.** The method of claim 12, further comprising:
receiving, by the processor, the codeword over a channel from another electronic device.

**14.** The method of claim 12 or 13, wherein the vectors are decoded sequentially and a matrix of the corresponding matrices comprises any outer codewords corresponding to previously decoded vectors.

**15.** The method of any one of claims 12 to 14, wherein the non-linear NN outer decoding processes use same NN weights.

FIG. 1

FIG. 2

EP 4 637 038 A1

**u** → Encoder 302 $f_\theta(.)$ → **x** → Channel 304 → **y** → Decoder 306 $g_\phi(.)$ → $\widehat{\mathbf{u}}^{(\text{list})} = \begin{bmatrix} \widehat{\mathbf{u}}_1^{(\text{list})} \\ \vdots \\ \widehat{\mathbf{u}}_L^{(\text{list})} \end{bmatrix}$

FIG. 3

FIG. 4

Outer enc. #1
$f_{enc,1}^{(o)}(.)$
502

$\mathbf{u}_1$
$K_1$ info. bits
Info. Set $\mathcal{A}_1$

$\mathbf{c}_1^{(o)}$
Length $N_{out}$

Outer enc. #2
$f_{enc,2}^{(o)}(.)$
504

$\mathbf{u}_2$
$K_2$ info. bits
Info. Set $\mathcal{A}_2$

$\mathbf{c}_2^{(o)}$
Length $N_{out}$

Outer enc. #3
$f_{enc,3}^{(o)}(.)$
506

$\mathbf{u}_3$
$K_3$ info. bits
Info. Set $\mathcal{A}_3$

$\mathbf{c}_3^{(o)}$
Length $N_{out}$

Outer enc. #4
$f_{enc,4}^{(o)}(.)$
508

$\mathbf{u}_4$
$K_4$ info. bits
Info. Set $\mathcal{A}_4$

$\mathbf{c}_4^{(o)}$
Length $N_{out}$

$$\mathbf{C}^o = \begin{bmatrix} \mathbf{c}_1^{(o)} \\ \vdots \\ \mathbf{c}_4^{(o)} \end{bmatrix}$$

Enc. Polarization network

$\kappa: 4 \rightarrow 4$

510

$\mathbf{C}_{4 \times N_{out}}$

FIG. 5

FIG. 6

FIG. 7

FIG. 8

$$\mathbf{Y} = \begin{bmatrix} \mathbf{Y}_1 \\ \vdots \\ \mathbf{Y}_{M_{out}} \end{bmatrix}$$

Reshaped received word of size $M_{out} \times N_{out}$

Bit-channel #1 **802**
$g^{(0)} : M_{out} \rightarrow 1$
$\begin{bmatrix} \mathbf{Y}_1 \\ \vdots \\ \mathbf{Y}_{M_{out}} \end{bmatrix}$

Outer decoder $f_{dec}^{(o)}$ **804**
$[\boldsymbol{\lambda}_1^{out}, \mathbf{P}_1]$ $1 \times 2N_{out}$
$\hat{\mathbf{c}}_1$ $1 \times N_{out}$
$\hat{\mathbf{u}}_1$ $1 \times N_{out}$

Bit-channel #2 **806**
$g^{(1)} : M_{out} + 1 \rightarrow 1$
$\begin{bmatrix} \hat{\mathbf{c}}_1 \\ \mathbf{Y}_1 \\ \vdots \\ \mathbf{Y}_{M_{out}} \end{bmatrix}$

Outer decoder $f_{dec}^{(o)}$ **808**
$[\boldsymbol{\lambda}_2^{out}, \mathbf{P}_2]$ $1 \times 2N_{out}$
$\hat{\mathbf{c}}_2$ $1 \times N_{out}$
$\hat{\mathbf{u}}_2$ $1 \times N_{out}$

Bit-channel #$M_{out} - 1$ **810**
$g^{(M_{out}-2)} : 2M_{out} - 2 \rightarrow 1$
$\begin{bmatrix} \hat{\mathbf{c}}_1 \\ \vdots \\ \hat{\mathbf{c}}_{M_{out}-2} \\ \mathbf{Y}_1 \\ \vdots \\ \mathbf{Y}_{M_{out}} \end{bmatrix}$

Outer decoder $f_{dec}^{(o)}$ **812**
$[\boldsymbol{\lambda}_{M_{out}-1}^{out}, \mathbf{P}_{M_{out}-1}]$ $1 \times 2N_{out}$
$\hat{\mathbf{c}}_{M_{out}-1}$ $1 \times N_{out}$
$\hat{\mathbf{u}}_{M_{out}-1}$ $1 \times N_{out}$

Bit-channel #$M_{out}$ **814**
$g^{(M_{out}-1)} : 2M_{out} - 1 \rightarrow 1$
$\begin{bmatrix} \hat{\mathbf{c}}_1 \\ \vdots \\ \hat{\mathbf{c}}_{M_{out}-1} \\ \mathbf{Y}_1 \\ \vdots \\ \mathbf{Y}_{M_{out}} \end{bmatrix}$

Outer decoder $f_{dec}^{(o)}$ **816**
$[\boldsymbol{\lambda}_{M_{out}}^{out}, \mathbf{P}_{M_{out}}]$ $1 \times 2N_{out}$
$\hat{\mathbf{c}}_{M_{out}-1}$ $1 \times N_{out}$
$\hat{\mathbf{u}}_{M_{out}}$ $1 \times N_{out}$

FIG. 9

```
┌─────────────────────────────┐
│ Partition binary message word into │──── 1002
│         segments            │
└─────────────────────────────┘
              │
              ▼
┌─────────────────────────────┐
│ Encode segments into outer codewords │──── 1004
│       using NN outer encoders        │
└─────────────────────────────┘
              │
              ▼
┌─────────────────────────────┐
│   Combine outer codewords using   │──── 1006
│      polarization operation       │
└─────────────────────────────┘
              │
              ▼
┌─────────────────────────────┐
│ Apply power normalization to generate │──── 1008
│          a final codeword          │
└─────────────────────────────┘
              │
              ▼
┌─────────────────────────────┐
│ Transmit final codeword over channel │──── 1010
└─────────────────────────────┘
```

FIG. 10

```
┌─────────────────────────────────┐
│  Receive codeword over a channel │──── 1102
└─────────────────────────────────┘
                 │
                 ▼
┌─────────────────────────────────┐
│  Generate vectors from matrices of the │──── 1104
│  codeword using polarization operations │
└─────────────────────────────────┘
                 │
                 ▼
┌─────────────────────────────────┐
│  Decode the vectors using NN outer │──── 1106
│  decoders to generate segments   │
└─────────────────────────────────┘
                 │
                 ▼
┌─────────────────────────────────┐
│  Determine a binary message word from │──── 1108
│  the segments                    │
└─────────────────────────────────┘
```

FIG. 11

EP 4 637 038 A1

1200

**Electronic Device**
1201

**Processor**
1220

| Main Processor 1221 | Auxiliary Processor 1223 |

**Memory**
1230

Volatile Memory 1232

**Non-Volatile Memory**
1234

| Internal Memory 1236 | External Memory 1238 |

| Input Device 1250 | Sound Output Device 1255 |

| Display Device 1260 | Audio Module 1270 |

| Sensor Module 1276 | Interface 1277 |

| Haptic Module 1279 | Camera Module 1280 |

| Power Management Module 1288 | Battery 1289 |

**Communication Module**
1290

Wireless Communication Module 1292

Wired Communication Module 1294

**Connecting Terminal**
1278

| Subscriber Identification Module 1296 | Antenna Module 1297 |

**Program**
1240

Operating System 1242

Middleware 1244

Application 1246

**Electronic Device**
1204

**Network**
1299

1298

**Server**
1208

**Electronic Device**
1202

FIG. 12

Europäisches
Patentamt

European
Patent Office

Office européen
des brevets

## EUROPEAN SEARCH REPORT

**Application Number**

EP 25 17 0660

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | SABER HAMID ET AL: "Generalized Concatenated Polar Auto-Encoder: A Deep Learning Based Polar Coding Scheme", GLOBECOM 2024 - 2024 IEEE GLOBAL COMMUNICATIONS CONFERENCE, IEEE, 8 December 2024 (2024-12-08), pages 1942-1947, XP034857610, DOI: 10.1109/GLOBECOM52923.2024.10901269 [retrieved on 2025-03-11] * the whole document * | 1-15 | INV. H03M13/29 H03M13/37 H03M13/00 H04L1/00 G06N3/0455 ADD. H03M13/13 H03M13/21 H03M13/09 H03M13/45 |
| A | SABER HAMID ET AL: "Design of Generalized Concatenated Codes Based on Polar Codes With Very Short Outer Codes", IEEE TRANSACTIONS ON VEHICULAR TECHNOLOGY, IEEE, USA, vol. 66, no. 4, 1 April 2017 (2017-04-01), pages 3103-3115, XP011645880, ISSN: 0018-9545, DOI: 10.1109/TVT.2016.2591584 [retrieved on 2017-04-14] * the whole document * | 1-15 | |
| A | US 2023/361789 A1 (KIM SUNGJIN [KR] ET AL) 9 November 2023 (2023-11-09) * the whole document * | 1-15 | **TECHNICAL FIELDS SEARCHED (IPC)** H03M G06N H04L |

-/--

The present search report has been drawn up for all claims

| Place of search | Date of completion of the search | Examiner |
|---|---|---|
| Munich | 21 August 2025 | Wu, Zifeng |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

| | Europäisches Patentamt European Patent Office Office européen des brevets | **EUROPEAN SEARCH REPORT** | **Application Number** EP 25 17 0660 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Hebbar S Ashwin ET AL: "DEEPPOLAR: Inventing Nonlinear Large-Kernel Polar Codes via Deep Learning", arXiv.org, 14 February 2024 (2024-02-14), pages 1-18, XP093306825, Ithaca, New York, USA DOI: https://doi.org/10.48550/arXiv.2402.08864 Retrieved from the Internet: URL:https://arxiv.org/abs/2402.08864v1 [retrieved on 2025-08-21] * the whole document * | 1-15 | |
| A | SABER HAMID ET AL: "List Autoencoder: Towards Deep Learning Based Reliable Transmission Over Noisy Channels", GLOBECOM 2022, 2022 IEEE GLOBAL COMMUNICATIONS CONFERENCE, [Online] 3 August 2022 (2022-08-03), pages 1454-1459, XP093110854, DOI: 10.1109/GLOBECOM48099.2022.10001468 ISBN: 978-1-6654-3540-6 Retrieved from the Internet: URL:https://arxiv.org/pdf/2112.11920.pdf> * the whole document * | 1-15 | **TECHNICAL FIELDS SEARCHED (IPC)** |
| A,P | ANKIREDDY SRAVAN KUMAR ET AL: "Nested Construction of Polar Codes via Transformers", 2024 IEEE INTERNATIONAL SYMPOSIUM ON INFORMATION THEORY (ISIT), IEEE, 7 July 2024 (2024-07-07), pages 1409-1414, XP034672647, DOI: 10.1109/ISIT57864.2024.10619466 [retrieved on 2024-08-19] * the whole document * | 1-15 | |

| The present search report has been drawn up for all claims | | |
|---|---|---|
| Place of search **Munich** | Date of completion of the search **21 August 2025** | Examiner **Wu, Zifeng** |

## ANNEX TO THE EUROPEAN SEARCH REPORT
## ON EUROPEAN PATENT APPLICATION NO.

EP 25 17 0660

This annex lists the patent family members relating to the patent documents cited in  the above-mentioned European search report.
The members are as contained in the European Patent Office EDP file on
The European Patent Office is in no way liable for these particulars which are merely given for the purpose of information.

21-08-2025

| Patent document cited in search report | Publication date | Patent family member(s) | | Publication date |
|---|---|---|---|---|
| US 2023361789 A1 | 09-11-2023 | KR | 20230075466 A | 31-05-2023 |
| | | US | 2023361789 A1 | 09-11-2023 |
| | | WO | 2022071642 A1 | 07-04-2022 |

EPO FORM P0459

For more details about this annex : see Official Journal of the European Patent Office, No. 12/82